# EUROPEAN PATENT APPLICATION

(11) **EP 4 719 029 A1**
(43) Date of publication of application: **01.04.2026**
(21) Application number: 25202598.6
(22) Date of filing: 16.09.2025
(51) Int. Cl.: H10W 20/43, H10W 20/00, H10D 30/00, H10W 70/60, H10D 62/10, H10D 84/01, H10D 84/03

(54) **GATE TO SOURCE/DRAIN CONTACT LINKS IMPLEMENTED IN METALLIZATION LAYER CONTACTING DEVICE LAYER**

(30) Priority: 27.09.2024 US 202418900320
(71) Applicant: Intel Corporation, Santa Clara, CA 95054 (US)
(72) Inventor: GULER, Leonard, Hillsboro, 97124 (US); ACHARYA, Saurabh, Beaverton, 97007 (US); LIU, Shengsi, Portland, 97229 (US)
(74) Representative: 2SPL Patentanwälte PartG mbB

(57) **Abstract**

Integrated circuit (IC) devices having transistors with gate electrodes coupled to a source or drain, for example, diode-connected transistors.

An IC device may include a metallization level on a transistor (e.g., on and over a device layer), with a continuous first metal body in the metallization level and directly on a source or drain contact and the gate electrode. A second metal body in the metallization level may be on the other of the source or drain contacts. The metallization level (including the first and second metal bodies) may have a lower interface plane that contacts an upper contact plane of the transistor (e.g., gate electrode and source and drain contacts). The metallization level may have an upper interface plane that may be contacted by vias from an interconnect network over the transistor.

## Description

### BACKGROUND

Coupling terminals of a transistor, for example, diode-connecting a transistor, may conventionally be done within a device layer or up in an interconnect stack, potentially well away from the transistor. Making these connections within a device layer may involve extra patterning and removing material from delicate structures in constrained spaces. Making these connections up in an interconnect stack may employ excessive routing.

New techniques and structures are needed to improve transistor diode connections in integrated circuit devices.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A, 1B, 1C, 1D, and 1E illustrate isometric, plan, and cross-sectional profile views of an integrated circuit (IC) device having linking bodies coupling gate electrodes and source or drain contact metals at contact and metallization planes at an upper surface of diode-connected transistor structures, in accordance with some embodiments;
FIG. 2 is a flow chart of methods for forming a metallization level with linking bodies on gate electrodes and drain and source contacts, in accordance with some embodiments;
FIGS. 3A, 3B, 3C, 3D, 3E, and 3F illustrate isometric and plan views of an IC device having metal bodies in a metallization level directly on gate electrodes and contact metals in a contact level, at various stages of manufacture, in accordance with some embodiments;
FIG. 4 illustrates a diagram of an example data server machine employing an IC device having a metallization layer on a transistor and linking a gate electrode and a source or drain contact, in accordance with some embodiments; and
FIG. 5 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Structures and techniques are disclosed to improve linking structures and processing efficiencies in integrated circuit (IC) devices having diode-connected transistors.

Diode-connected transistors are employed for a variety of purposes, including as diodes, but also as large resistors and in current mirrors, which also have a multitude of applications. While a MOS (metal-oxide-semiconductor) FET (field-effect transistor) may be diode connected by electrically tying the gate to the drain, the drain and source bodies are often physically symmetrical in FETs, so the described techniques and structures may be utilized for gate-source connections as well. Transistor terminals may be electrically coupled conventionally, up in an interconnect stack over the transistor (for example, at met0, met1, etc.), but excessive routing may have electrical drawbacks (e.g., increased parasitics, etc.) and add avoidable complexity. Alternatively, other electrical connections may be made by etching into a gate electrode and source or drain contact metal in a device layer, but such patterning wastes processing resources (e.g., by adding extra masking, etc.) and may raise risks of reliability issues (e.g., by etching through one or more material layers in very constrained and critical spaces). The techniques and structures described herein conserve processing operations without these reliability risks.

Transistors may be diode connected by coupling gate electrodes with source and/or drain contacts in a metallization level immediately above a device layer, but below a conventional interconnect stack. Processing operations may be conserved by utilizing a metallization level otherwise dedicated to coupling source and drain contacts between neighboring transistors. A gate-drain (or gate-source) metallization link may be deposited directly on an upper surface of a transistor (and the gate electrode and source or drain contact). This direct interfacing of a metallization plane and the contact plane may minimize both reliability issues and mask operations, producing robust structures while efficiently utilizing processing resources.

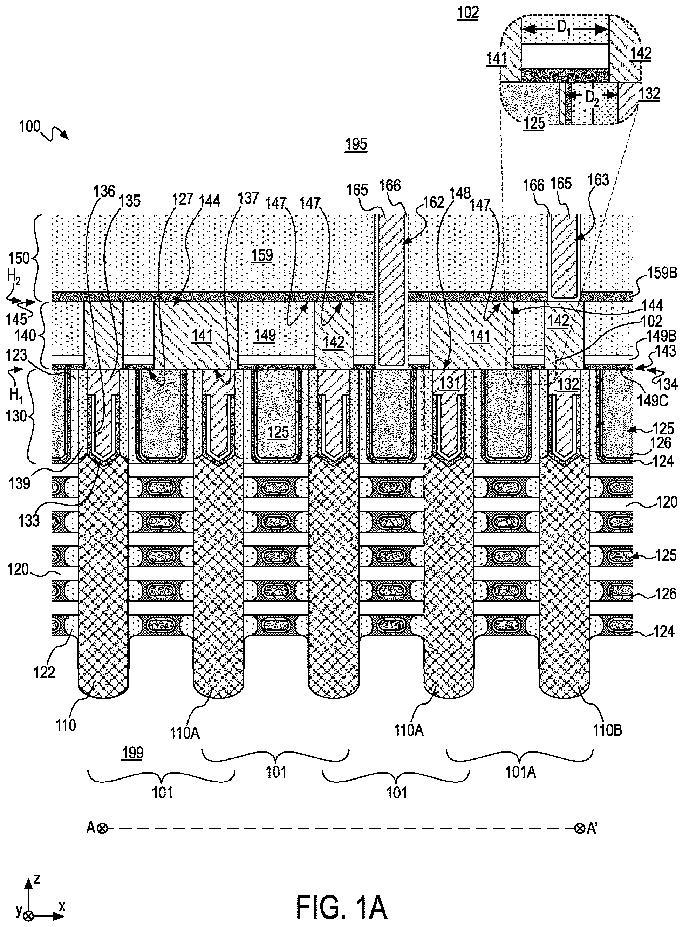

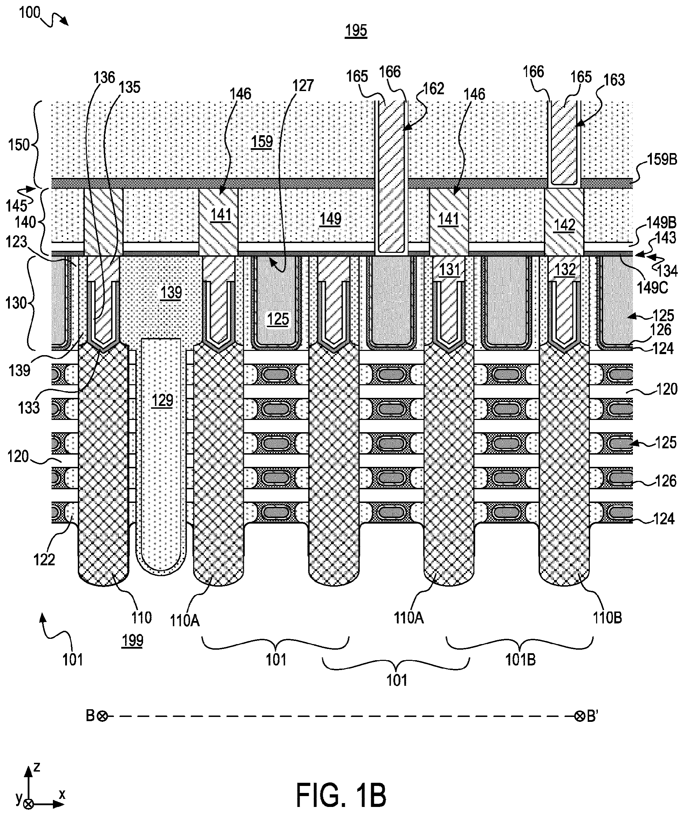

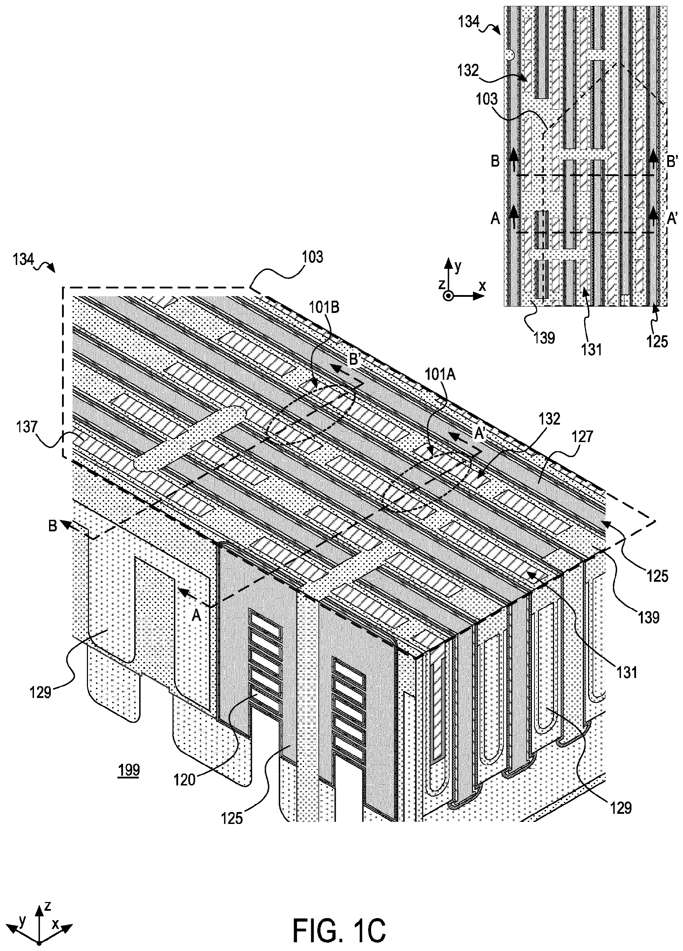

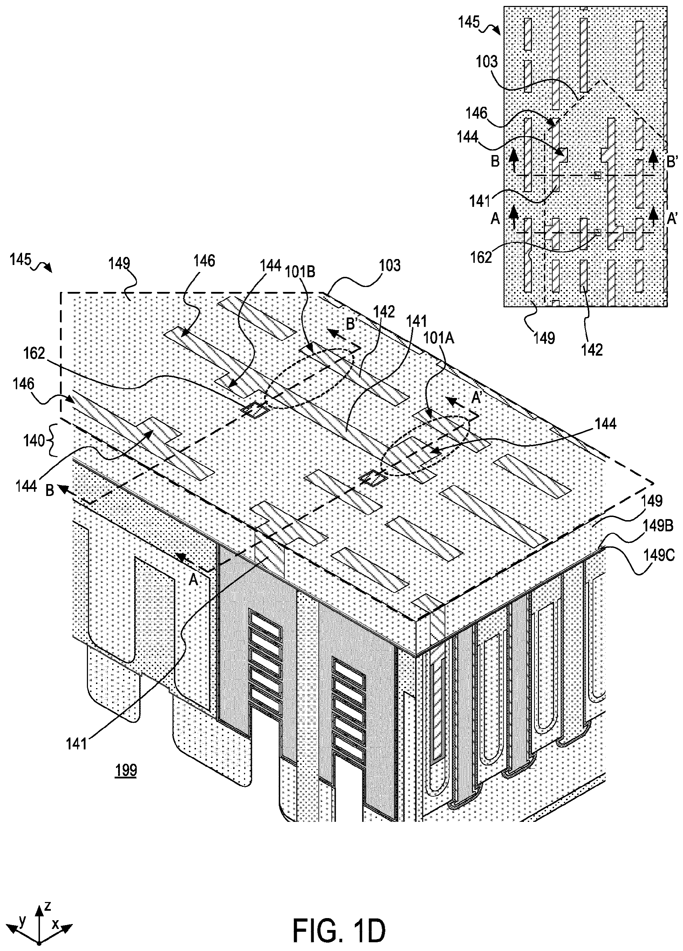

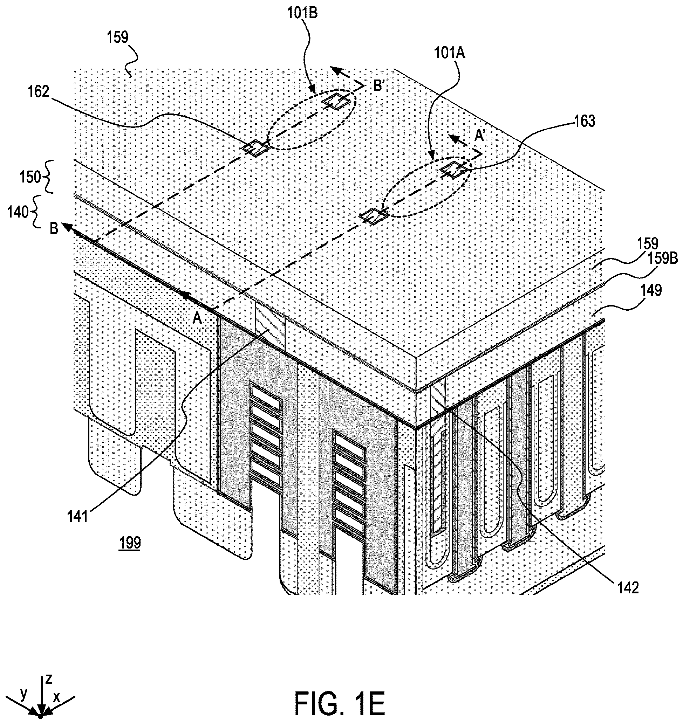

FIGS. 1A, 1B, 1C, 1D, and 1E illustrate isometric, plan, and cross-sectional profile views of an IC device 100 having linking bodies 141 coupling gate electrodes 125 and source or drain contact metals 131, 132 at contact and metallization planes 134, 143 at an upper surface 147 of diode-connected transistor structures 101, in accordance with some embodiments. Transistor structure 101 may be coupled with an interconnect level 150 and interconnect network 195 by a metallization level 140 directly on a contact level 130 of or on transistor structure 101. FIG. 1A shows a cross-sectional profile view A-A'of device 100 through a row of transistor structures 101, including diode-connected structures 101 with metal bodies 141, 142 on gate electrodes 125 and source and drain metals 131, 132. FIG. 1B illustrates a cross-sectional profile view B-B'of device 100 through a second row of transistor structures 101, coupled to the first row of transistor structures 101 by linking bodies 141 and/or 142 on source and drain metals 131, 132 in each row of structures 101. FIGS. 1C-1E show isometric and plan views of (and above) contact and metallization planes 134, 143, 145, including the orientations of profile views A-A' and B-B'of FIGS. 1A and 1B.

Apparatus or device 100 includes transistor structures 101 over substrate 199. Transistor structure 101 (e.g., structure 101A) includes source and drain bodies 110 and a channel structure 120 between and coupling source and drain bodies 110. Structure 101A includes a gate electrode 125 over channel structure 120. Substrate 199 may include or support multiple transistor structures 101, for example, over subfins extending up from a crystalline layer of a semiconductor or insulator material.

Contact level 130 provides structures and surfaces for interfacing between metallization level 140 and transistor structures 101. Contact level 130 may be above (or the uppermost level 130 of) a device layer including transistor structures 101. Contact level 130 is below metallization level 140 and includes gate electrode 125, source contact metal 132, and drain contact metal 131. Source contact metal 132 is on source body 110B and over source body 110B, and drain contact metal 131 is on drain body 110A and over drain body 110A.

Gate electrode 125 extends up over channel structure 120 (e.g., in the z-direction) and into contact level 130. Gate electrode 125 is over channel structure 120 (e.g., in the z-direction) and to both sides of channel structure 120 (e.g., in both y-directions, in front of and behind the x-z viewing plane of FIG. 1A). In the exemplary embodiment of FIG. 1A, which has nanoribbon stacks as structures 120, electrode 125 is within, through, or between channel structures 120, for example, extending between individual nanoribbons (e.g., extending in the y-directions over one nanoribbon in a channel structure 120 and under another nanoribbon in the same channel structure 120).

Contact level 130 has an upper, top plane 134. Upper surface 137 of source contact metal 132, upper surface 137 of drain contact metal 131, and upper surface 127 of gate electrode 125 are coplanar in contact plane 134 above the channel structure 120. The contact plane 134 of contact level 130 interfaces with the metallization plane 143 of metallization level 140. The interfacing of contact and metallization levels 130, 140 (and, e.g., of bodies 141, 142 with electrodes 125 and metals 131, 132) at contact and metallization planes 134, 143 refers to the direct contact of levels 130, 140 at planes 134, 143, without any intervening levels or structures. Metallization level 140 is directly on contact level 130.

Metallization level 140 interfaces with contact level 130 (at contact and metallization planes 134, 143), interfacing with each of source contact metal 132, drain contact metal 131, and gate electrode 125. Metallization level 140 includes first and second metal bodies 141, 142 between a lower, bottom plane 143 and an upper, top plane 145. A lower surface 148 of metal body 141 and lower surface 148 of metal body 142 are substantially coplanar in bottom metallization plane 143 at a first height H₁ above channel structure 120. An upper surface 147 of metal body 141 and upper surface 147 of metal body 142 are substantially coplanar in top metallization plane 145 at a second height H₂ above the channel structure 120 and above the first height H₁ of metallization plane 143 above channel structure 120.

First metal body 141 couples gate electrode 125 to one of source or drain bodies 110. First metal body 141 in level 140 interfaces at metallization plane 143 (and contact plane 134) with gate electrode 125 and one of drain and source contact metals 131, 132. Second metal body 142 in level 140 interfaces at metallization plane 143 (and contact plane 134) with the other of drain and source contact metals 131, 132. In some embodiments, either or both of bodies 141, 142 interface with other drain and/or source contact metals 131, 132 in other transistor structures 101. For example, metal bodies 141 and/or 142 may extend in the y-direction, orthogonal to a longitudinal direction of channel structures 120, and contact drain and/or source contact metals 131, 132 in transistor structures 101 with channel structures 120 parallel to those described at FIG. 1A.

In the exemplary embodiment of FIG. 1A, body 141 contacts gate electrode 125 and drain metal 131, and body 142 contacts source metal 132. Drain and source bodies 110 in FET structures 101 are often symmetrical and may be determined by electrical connections (e.g., to a power supply via interconnect network 195), so the labels provided for any specific embodiment, e.g., of FIG. 1A (for example, drain and source bodies 110A, 110B and metals 131, 132 in transistor structure 101A), should not be understood as limiting for these or other embodiments, e.g., which may have different or undetermined electrical connections.

Metal bodies 141, 142 are in a dielectric layer 149 in metallization level 140, over contact level 130. Metallization level 140 may include multiple dielectric layers 149, such as dielectric layers 149B, 149C at a bottom of level 140 (e.g., with dielectric layer 149C on metallization plane 143). For example, metallization level 140 may include dielectric layers 149B, 149C as etch-stop layers 149B, 149C over contact level 130 and a device layer including transistor structures 101. The bulk or majority of dielectric layer 149 may advantageously be of a low-K (low-permittivity) dielectric material, e.g., to electrically insulate metallic bodies 141, 142 from each other, via 162, etc. Etch-stop layers 149B, 149C may advantageously be of low-K dielectric materials, but etch-stop layers 149B, 149C may provide etch selectivities and may have higher permittivities than the bulk or majority of dielectric layer 149.

Metal bodies 141, 142 may include any suitable materials, including non-metals. In many embodiments, bodies 141, 142 include one or more of tungsten, molybdenum, cobalt, ruthenium, copper, gold, tantalum, aluminum, nickel, or other metals, including in alloys. Bodies 141, 142 may include other electrically conductive materials, including non-metals. In some embodiments, bodies 141, 142 include nitrides of metals, e.g., tantalum and titanium. In some embodiments, bodies 141, 142 include multiple materials, for example, with one or more conformal metal layers (e.g., barrier and/or seed layers) on sidewalls of dielectric layer 149 as a liner around a different bulk or fill metal within or surrounded by the liner. In many embodiments, bodies 141, 142 have identical compositions, e.g., due to concurrent depositions into metallization level 140.

Metal body 141 is on, and continuous between, gate electrode 125 and drain contact metal 131. Metal bodies 141, 142 are continuous between drain and source contact metals 131, 132 and upper plane 145. In embodiments with one or both of bodies 141, 142 interfacing with drain and/or source contact metals 131, 132 in other transistor structures 101, bodies 141, 142 are on, and continuous between, gate electrode 125 and drain and/or source contact metals 131, 132. In some embodiments, bodies 141, 142 have multiple metal layers, one or both of bodies 141, 142 interface with gate electrode 125 and contact metals 131 or 132, and the interfacing body 141 or 142 is continuous between gate electrode 125 and contact metal 131 and/or 132. For example, although there may be an interface (e.g., a seam) between the layers of the interfacing body 141 or 142, each of the layers spans and is continuous between the electrode 125 and contact metal 131 and/or 132 (e.g., with the interface also spanning between electrode 125 and metal 131 and/or 132). There is no seam or interface between electrode 125 and metal 131 and/or 132.

Bodies 141, 142 may be oriented (e.g., sized and spaced) to optimize performance of device 100, e.g., to ensure sufficient interface area while minimizing parasitic capacitances. In many embodiments, as in the example of magnified view 102, a first distance D₁ separating metal bodies 141, 142 is greater than a second distance D₂ separating gate electrode 125 and source contact metal 132. Body 141 is large enough to overlap electrode 125 sufficiently, but increased space (e.g., distance D₁) is left between bodies 141, 142 (e.g., relative to a body 141 completely covering electrode 125).

In the exemplary embodiment of transistor structures 101A, 101B in FIGS. 1A and 1B, body 141 includes first portion 144 (as shown in FIG. 1A) and a second portion (e.g., portion 146 shown in FIG. 1B). Body 141 is continuous between portions 144, 146, as described. First portion 144 extends in the x-directions between gate electrode 125 and drain contact metal 131 of structure 101A. As will be described at FIG. 1B, second portion 146 of body 141 extends in the y-directions (e.g., behind the viewing plane of FIG. 1A, into the x-z viewing plane of FIG. 1B) and contacts a drain or source contact metal 131, 132 on a drain or source body 110 of another transistor structure 101B.

Contact metals 131, 132 may be conductive (e.g., metal) materials or structures that contact source or drain bodies 110. Contact metals 131, 132 may couple regions 110 (and transistor structures 101) to interconnect level 150 and network 195, e.g., over transistor structures 101. Contact metals 131, 132 may include any suitable material(s), including non-metals, for example, as described of metal bodies 141, 142. In some embodiments, bodies 141, 142 have a first composition different than a second composition of contact metals 131, 132, but metals 131, 132 may have a composition substantially the same as a composition of bodies 141, 142. For example, in many embodiments, metals 131, 132 include the same one or more of tungsten, molybdenum, cobalt, ruthenium, copper, gold, tantalum, aluminum, nickel, or other metals or non-metals, including in alloys, nitrides, etc., in a bulk of contact metals 131, 132, but with additional layer 133 of a different metal.

In many embodiments, metals 131, 132 include multiple materials, for example, with one or more conformal metal layers 136 (e.g., barrier and/or seed layers 136) on source or drain bodies 110 or sidewalls of dielectric layer 139 as a liner around a different bulk or fill metal 135 within or surrounded by layer 136. In many embodiments, metals 131, 132 include an interfacing layer 133 on source or drain bodies 110 that is or includes an alloy of a metal (e.g., as previously listed) and a semiconductor material of a body 110 (e.g., a silicide layer 133). Dielectric layers 139 may be on sidewalls of metals 131, 132. Dielectric layers 139 may advantageously include a low-K dielectric material, such as a silicon oxide (e.g., silicon dioxide, SiO₂). Dielectric layers 139 may provide an etch selectivity, for example, with adjacent structures or materials during processing. In some embodiments, dielectric layers 139 include a silicon nitride, a silicon oxynitride, etc., either with or without carbon.

Dielectric layer 159 is in interconnect level 150 and over dielectric layer 149 and metallization level 140, and bodies 141, 142 interface with layer 159 (e.g., layer 159B) at plane 145. Interconnect level 150 may include multiple dielectric layers 159, such as dielectric layer 159B at a bottom of level 150 (e.g., with dielectric layer 159B on metallization level 140, including bodies 141, 142 and dielectric layer 149). The bulk or majority of dielectric layer 159 may advantageously be of a low-K dielectric material, e.g., to electrically insulate vias 162, 163 from each other. Etch-stop layer 159B may advantageously be of a low-K dielectric material, but etch-stop layer 159B may provide etch selectivities and may have higher permittivities than the bulk or majority of dielectric layer 159.

Vias 162, 163 couple transistor structure 101 with interconnect network 195. Vias 162, 163 are in interconnect level 150 and through at least interconnect level 150, which is a lowest level 150 of interconnect network 195. First via 163 extends through dielectric layer 159 and interconnect level 150 and interfaces with metal body 142 at upper metallization plane 145. First via 163 extends through dielectric layer 159 to the second height H₂ and contacts metal body 142. Second via 162 extends through dielectric layers 149, 159 and levels 140, 150 and interfaces with an uncoupled gate electrode 125 at lower metallization plane 143, e.g., an electrode 125 of another transistor structure 101 and not in contact with a metal body 141 or 142. Second via 162 extends through dielectric layers 149, 159 to first height H₁ and contacts a gate electrode 125 of the adjacent transistor structure 101.

Vias 162, 163 may include any suitable materials, including non-metals, for example, as described of metal bodies 141, 142. Via 162 may have a composition the same as, or different from, a composition of via 163. In some embodiments, bodies 141, 142 have a first composition different than a second composition of first and second vias 163, 162, but one or both of vias 162, 163 may have a composition the same as, or different from, a composition of bodies 141, 142. For example, in many embodiments, vias 162, 163 include one or more of tungsten, molybdenum, cobalt, ruthenium, copper, gold, tantalum, aluminum, nickel, or other metals or non-metals, including in alloys, nitrides, etc. In many embodiments, vias 162, 163 include multiple materials, for example, with one or more conformal metal layers 166 (e.g., barrier and/or seed layers 166) on sidewalls of dielectric layer 149 and/or 159 as a liner around a different bulk or fill metal 165 within or surrounded by layer 166.

Interfaces between contact and metallization levels 130, 140 may be demonstrated by metal-metal, metal-dielectric, dielectric-dielectric interfaces at planes 134, 143, 145. For example, in some embodiments, metal bodies 141, 142 at and above metallization plane 143 have a first composition different than a second composition of drain and source contact metals 131, 132 below contact plane 134 (and metallization plane 143). In some such embodiments, a seam is detectable (e.g., visibly or otherwise in cross-section) between bodies 141, 142 and metals 131, 132, where contiguous bodies 141, 142 and metals 131, 132 abut at interface planes 134, 143. In many embodiments, metal bodies 141, 142 at and above metallization plane 143 have a composition different than a composition of the gate electrode 125 below contact plane 134 (and metallization plane 143). In some such embodiments, a seam is detectable between abutting bodies 141, 142 and electrode 125 at interface planes 134, 143. Interfaces between metal bodies 141, 142 and contact metals 131, 132 or electrode 125 may include metallic bonding at abutting planes 134, 143.

Interfaces (e.g., metal-metal interfaces) may be detectable between metal bodies 141, 142 and contact metals 131, 132 having a same composition. In some embodiments, metal bodies 141, 142 have a same composition as drain and source contact metals 131, 132. If not visibly, a seam between bodies 141, 142 and metals 131, 132 is often still detectable (e.g., in cross-section) by other analyses. In some embodiments, metal bodies 141, 142 have a same composition as at least a portion of gate electrode 125. Even in embodiments having abutting metal bodies 141, 142 and contact metals 131, 132 and difficult to detect seams (e.g., along metallically bonded interface planes 134, 143 with a same composition above and below planes 134, 143), planes 134, 143 may be detected by overhangs or underhangs. For example, interface planes 134, 143 may be apparent where an overhang of body 141 or 142 extends beyond (e.g., in an x-direction) a sidewall of contact metal 131, 132 or gate electrode 125. Interface planes 134, 143 may also be apparent at an underhang, where a sidewall of body 141 or 142 is over contact metal 131, 132 or gate electrode 125.

Metal-metal interfaces may be detectable even when a bulk of metal bodies 141, 142 match a bulk of contact metals 131, 132 or gate electrode 125. For example, in embodiments with bulks of body 141 and electrode 125 having matching compositions, an interface may be detectable at planes 134, 143 where a liner metal 126 of electrode 125 terminates at plane 134 and body 141. In other embodiments, liner metal 126 terminates below surface 127 and plane 134. In the exemplary embodiment of FIG. 1A, liner metal 136 of contact metals 131, 132 terminates below plane 134, but in other embodiments, e.g., with bulks of bodies 141, 142 and metals 131, 132 having matching compositions, an interface may be detectable at planes 134, 143 where a liner metal 136 terminates at plane 134 and body 141 or 142. In some embodiments, a bulk of metal bodies 141, 142 match a bulk of contact metals 131, 132 or gate electrode 125, and an interface is detectable at planes 134, 143 where a liner metal (not shown) of 141, 142 abuts metals 131, 132 or electrode 125.

Interfaces between levels 130, 140, 150 may be demonstrated by metal-dielectric interfaces at planes 134, 143, 145. For example, upper metallization plane 145 may be apparent at interfaces of coplanar upper surfaces 147 of metal bodies 141, 142 with dielectric layer 159 (e.g., layer 159B) over bodies 141, 142. Dielectric layer 159 is in interconnect level 150 and over dielectric layer 149 and metallization level 140. Interface planes 134, 143 may be detectable at a meeting of either or both of bodies 141, 142 with either or both of dielectric layers 123, 139 and/or at a meeting of any of contact metals 131, 132 or gate electrode 125 with dielectric layer 149 (e.g., layer 149C). Upper surface 127 of dielectric layer 123 may be coplanar with upper surface 127 of gate electrode 125, and contact plane 134 and upper surface 127 of electrode 125 may be defined or distinguished by an interfacing of layer 123 at body 141 (or 142). In some embodiments, a meeting of body 141 with gate dielectric layer 124 on gate electrode 125 makes apparent interface planes 134, 143 (e.g., where upper surface 127 of gate dielectric layer 124 is coplanar with upper surface 127 of electrode 125). In other embodiments, layer 124 terminates below surface 127 and plane 134.

Interfaces between contact and metallization levels 130, 140 may be demonstrated by dielectric-dielectric interfaces at planes 134, 143, 145. For example, interface plane 145 may be apparent at interfaces of upper surface 147 of dielectric layer 149 with dielectric layer 159 (e.g., layer 159B) of interconnect level 150 over metallization level 140. Upper surface 147 of dielectric layer 149 is coplanar with upper surface 147 of metal body 141 and upper surface 147 of metal body 142 in top plane 145 of metallization level 140. Interface planes 134, 143 may be detectable at a meeting of either or both of dielectric layers 123, 139 with dielectric layer 149 (e.g., layer 149C). In some embodiments, a meeting of dielectric layer 149 with gate dielectric layer 124 makes apparent interface planes 134, 143. In other embodiments, layer 124 terminates below surface 127 and plane 134.

Transistor structures 101 of either conductivity type (e.g., n- or p-type) may be coupled to a power supply through interconnect network 195 (including interconnect level 150) by metallization level 140. Drain and source bodies 110 are of semiconductor material doped with donor or acceptor impurities (n- or p-type dopants), e.g., having increased charge-carrier availabilities and associated conductivities. Bodies 110 are electrically and physically coupled to opposite ends of channel structures 120. Drain and source bodies 110 may be polycrystalline or substantially monocrystalline, e.g., having long-range order at least adjacent ends of channel structures 120 and (for example, in embodiments having nanoribbon channel structures 120) merging or joining into a unitary body with few grain boundaries. Bodies 110 may include one or more electrically active impurities in a Group IV semiconductor material (e.g., silicon (Si), germanium (Ge), silicon germanium (SiGe), germanium tin (GeSn) alloy).

Channel structures 120 may be of any suitable material and structure. In the exemplary embodiment of FIG. 1A, structures 120 are stacks of silicon nanoribbons, but other embodiments may have other aspect ratios (such as of nanowires or nanosheets), structures (such as fins, etc.), or materials (such as Ge, SiGe, two-dimensional (2D) materials (e.g., transition metal dichalcogenides, TMDs), etc.

Gate electrode 125 layer 126 on gate dielectric layer 124 may include at least one of a p-type work function metal (WFM) or an n-type WFM, depending on whether the transistor is a PMOS or an NMOS transistor. In some embodiments, gate electrode 125 is a stack of two or more metal layers, where one or more metal layers are WFM layers and at least one metal layer is a fill metal layer. For a PMOS transistor, metals that may be used for the gate electrode include, but are not limited to, ruthenium, palladium, platinum, cobalt, nickel, and conductive metal oxides, e.g., ruthenium oxide. A p-type metal layer will enable the formation of a PMOS gate electrode with a work function that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as aluminum carbide, hafnium carbide, zirconium carbide, titanium carbide, and tantalum carbide. An n-type metal layer will enable the formation of an NMOS gate electrode with a work function that is between about 3.9 eV and about 4.2 eV.

Gate dielectric layer 124 provides electrical insulation between channel structures 120 and gate electrode 125. Layer 124 may have more than one layer. Layer 124 may be of any suitable material(s). The one or more layers of dielectric layer 124 may include a silicon oxide, silicon dioxide (e.g., SiO₂), a silicon oxynitride, etc. Advantageously, gate layer 124 includes a high-permittivity ("high-K") dielectric, which may improve transconductance and so electrostatic control of channel structures 120 by electrode 125. A high-k dielectric material may include one or more of various elements, such as hafnium, silicon, oxygen, titanium, tantalum, lanthanum, aluminum, zirconium, barium, strontium, yttrium, lead, scandium, niobium, and zinc, including in oxides of these elements and combinations of these elements. Any other suitable materials may be deployed.

Gate spacers 122 provide electrical insulation between channel structures 120 (in the case of nanoribbon channel structures 120 of FIG. 1A) and between gate electrode 125 and source and drain bodies 110. Gate spacer layers 123 provide electrical insulation between gate electrode 125 and source and drain bodies 110 and between gate electrode 125 and contact metals 131, 132. Dimple spacer 122 and spacer layers 123 may be of or include the same or different dielectric material(s). Spacer 122 and spacer layers 123 may include a silicon oxide, silicon dioxide (e.g., SiO₂), a silicon nitride, a silicon oxynitride, etc., either with or without carbon. Any other suitable materials may be deployed. Advantageously, spacer 122 and spacer layers 123 include a low-K dielectric.

Interconnect network 195 includes layers (such as interconnect level 150) with interconnections or wires that provide electrical routing, generally formed of metal or other electrically conductive material. Adjacent interconnect layers may be formed of different materials and by different methods. Metallization level 140 and interconnect level 150 and network 195 are over a device layer that includes transistor structures 101 and contact level 130. Adjacent metallization and interconnect layers are interconnected by vias, e.g., like vias 162, 163, that may be characterized as part of the metallization layers or between the metallization layers.

In the illustrated example, network 195 may be a front-side interconnect network 195 including M0, V0, M1, M2/V1, M3/V2, M4/V3, and M4-M12 metallization layers. However, network 195 may include any number of metallization layers such as eight or more metallization layers. Similarly, a back-side network 195 may include BM0, BM1, BM2, and BM3. However, network 195 may include any number of metallization layers such as two to five metallization layers. Metallization in network 195 is embedded within dielectric materials (such as layer 159).

Substrate 199 may include any suitable material or materials. Any suitable semiconductor or other material can be used. Substrate 199 may be any suitable substrate 199, such as a wafer, die, etc. Substrate 199 may include a crystalline material that transistors can be formed out of or over, such as monocrystalline or polycrystalline Si, Ge, SiGe, a III-V alloy material (e.g., gallium arsenide (GaAs)), a silicon carbide (SiC), a sapphire (Al₂O₃), or any combination thereof. In some embodiments, substrate 199 includes crystalline silicon and subsequent components are also silicon. In some embodiments, a crystalline material of substrate 199 is removed (e.g., by grinding) from a back-side of transistor structures 101 and replaced with an isolation material. Substrate 199 may be a silicon-on-insulator (SOI) substrate. Substrate 199 may also include semiconductor materials, metals, dielectrics, dopants, and other materials commonly found in IC substrates.

FIG. 1B illustrates a row of transistor structures 101 in an x-z plane of device 100, parallel to the row of structures 101 described at FIG. 1A, with at least one of structures 101 in FIG. 1B coupled to one of structures 101 in FIG. 1A by a linking body 141 or 142 on drain and/or source metals 131, 132 in each row of structures 101. A dielectric isolation 129 is between some of source or drain bodies 110. At least one of drain and source contact metals 131, 132 is not interfaced with a metal body 141, 142.

In the exemplary embodiment of transistor structures 101A, 101B in FIGS. 1A and 1B, body 141 includes first portion 144 (as described at FIG. 1A) and second portion 146. Body 141 is continuous between portions 144, 146. As described at FIG. 1A, first portion 144 extends in the x-directions between gate electrode 125 and drain contact metal 131. In FIG. 1B, second portion 146 (extending in the y-directions between the x-z viewing planes of FIGS. 1A and 1B) contacts drain contact metal 131 on drain body 110A of transistor structure 101B.

FIG. 1C shows isometric and plan views of contact plane 134 in device 100 as if sectioned through by x-y, y-z, and x-z viewing planes, including the orientations of profile views A-A' and B-B' of FIGS. 1A and 1B. Dashed outlines of x-y section 103 in both the isometric and plan views provide further reference to, and aids comparison of, the views. Note that more of plane 134 is visible in the plan view than the isometric view, beyond section 103. Note also that some of profile views A-A' and B-B' of FIGS. 1A and 1B are beyond section 103. Dashed ovals indicate areas over transistor structures 101A, 101B along cross-sectional views A-A' and B-B' of FIGS. 1A and 1B.

Gate electrodes 125 (e.g., upper surfaces 127) and drain and source contact metals 131, 132 (e.g., upper surfaces 137) are revealed at x-y contact plane 134. Dielectric layer 139 is between electrodes 125 and contact metals 131, 132 extending in the y-directions. Dielectric layer 139 is between some pairs of electrodes 125 and some pairs of contact metals 131, 132, for example, separating or isolating adjacent transistor structures 101.

The sectioning of device 100 reveals a y-z plane through a track of gate electrodes 125. Channel structures 120 extend in the x-directions through gate electrodes 125. Dielectric isolation 129 is visible in the y-z plane (along an edge of section 103) in place of some electrodes 125, including on view B-B'.

The sectioning of device 100 includes an x-z plane through gate electrodes 125 and at least one drain or source contact metal 131 or 132 (but not the associated drain or source body 110). A dielectric isolation 129 is visible in the x-z plane in place of (or between) some of contact metals 131, 132.

FIG. 1D illustrates isometric and plan views of upper metallization plane 145 in device 100 as if sectioned through by x-y, y-z, and x-z viewing planes, including the orientations of profile views A-A' and B-B' of FIGS. 1A and 1B. Dashed outlines of x-y section 103 are in both the isometric and plan views. Dashed ovals indicate areas over transistor structures 101A, 101B along cross-sectional views A-A' and B-B' of FIGS. 1A and 1B.

Upper surfaces of metal bodies 141, 142 are revealed at x-y metallization plane 145 at a top of metallization level 140. Dielectric layer 149 is between bodies 141, 142 extending mostly in the y-directions. First portions 144 of bodies 141 extend in the x-directions (e.g., parallel to and over channel structures 120). Second portions 146 of bodies 141 extend in the y-directions, e.g., parallel to and on contact metals 131, 132, in some cases coupling contact metals 131, 132 in different transistor structures 101. For example, at least one body 141 is over transistor structures 101A, 101B (e.g., on metals 131 of structures 101A, 101B), with portion 146 of body 141 extending in the y-directions between structures 101A, 101B and with portions 144 extending in the x-directions (e.g., on and coupling gate electrodes 125 and metals 131 within each of structures 101A, 101B).

Vias 162 are revealed at plane 145 at a top of metallization level 140 (e.g., at a midpoint of vias 162 extending down from interconnect level and network, into and through level 140). Vias 162 are over gate electrodes 125 (e.g., on and coupling electrodes 125).

The sectioning of device 100 includes a y-z plane and an x-z plane through metal bodies 141, 142 and dielectric layer 149 in metallization level 140, which includes dielectric layers 149B, 149C at a bottom of metallization level 140.

FIG. 1E shows an isometric view of a top of interconnect level 150 in device 100 as if sectioned through by x-y, y-z, and x-z viewing planes, including the orientations of profile views A-A' and B-B' of FIGS. 1A and 1B. Dashed ovals indicate areas over transistor structures 101A, 101B along cross-sectional views A-A' and B-B' of FIGS. 1A and 1B.

Vias 162, 163 are visible at an x-y plane over interconnect level 150. Dielectric layer 159 is in level 150, over metallization level 140. Via 163 extends down from interconnect network 195 and through interconnect level 150 to bodies 141, 142 (e.g., touching down on and coupling bodies 141, 142). Via 162 extends down from interconnect network 195 and through interconnect level 150 and metallization level 140 to gate electrodes 125 (e.g., touching down on and coupling electrodes 125).

The sectioning of device 100 includes a y-z plane and an x-z plane through metal bodies 141, 142 and dielectric layers 149, 159 in levels 140, 150. Interconnect level 150 includes dielectric layers 159B at a bottom of level 150.

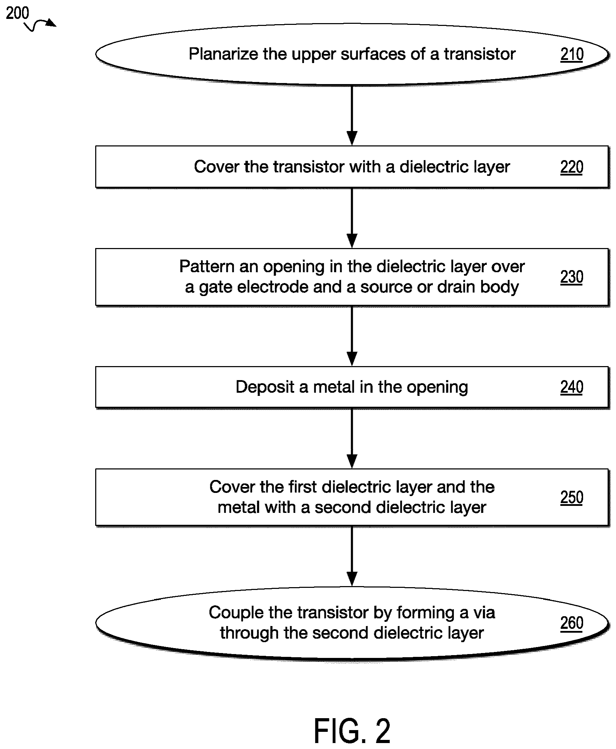

FIG. 2 is a flow chart of methods 200 for forming a metallization level with linking bodies on gate electrodes and drain and source contacts, in accordance with some embodiments. Methods 200 include operations 210-260. Some operations shown in FIG. 2 are optional. Additional operations may be included. FIG. 2 shows an example sequence, but the operations can be done in other orders as well, and some operations may be omitted. Some operations can also be performed multiple times before other operations are performed. For example, multiple openings may be patterned in a first dielectric layer before covering the first dielectric layer with a second dielectric layer. Some operations may be included within other operations so that the number of operations illustrated FIG. 2 is not a limitation of the methods 200.

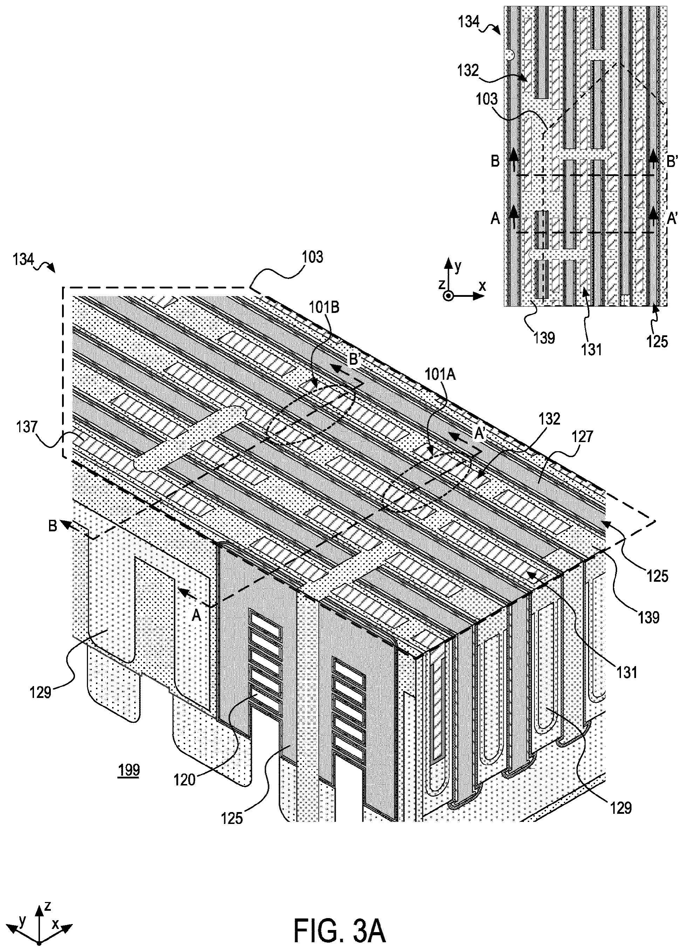

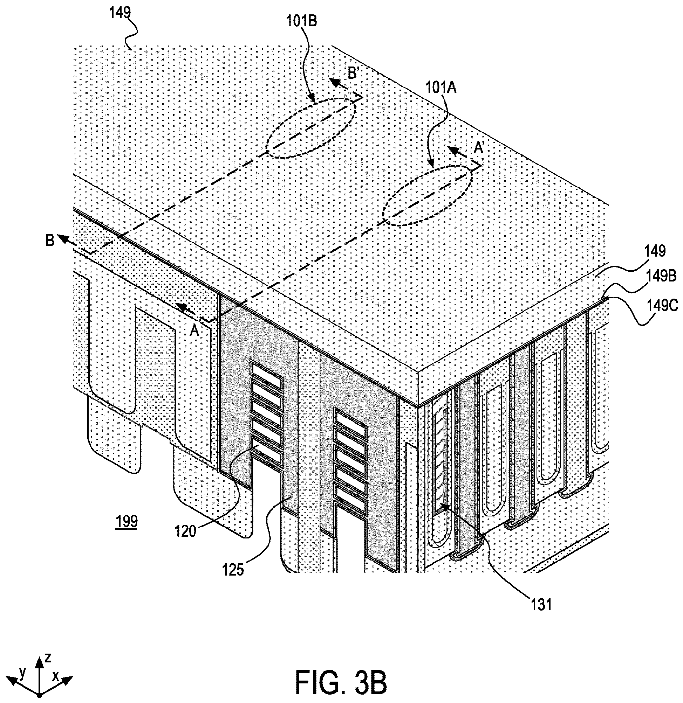

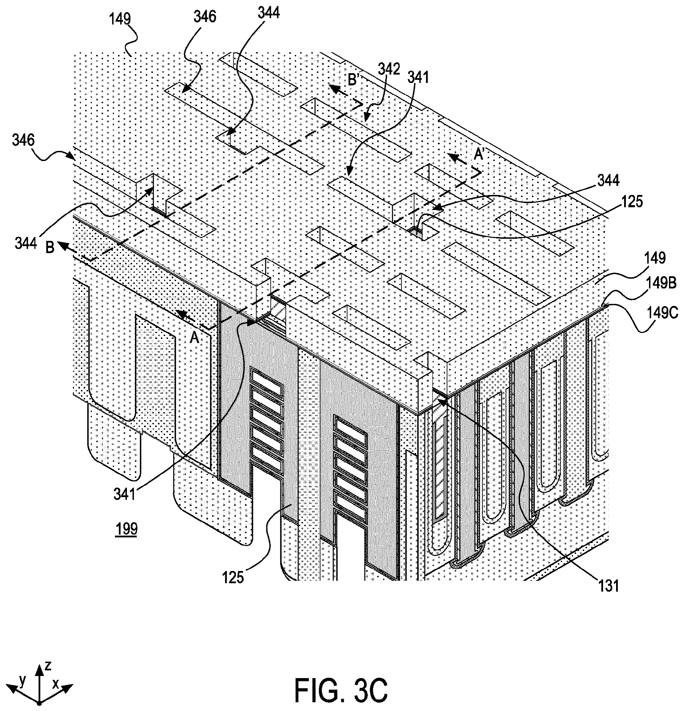

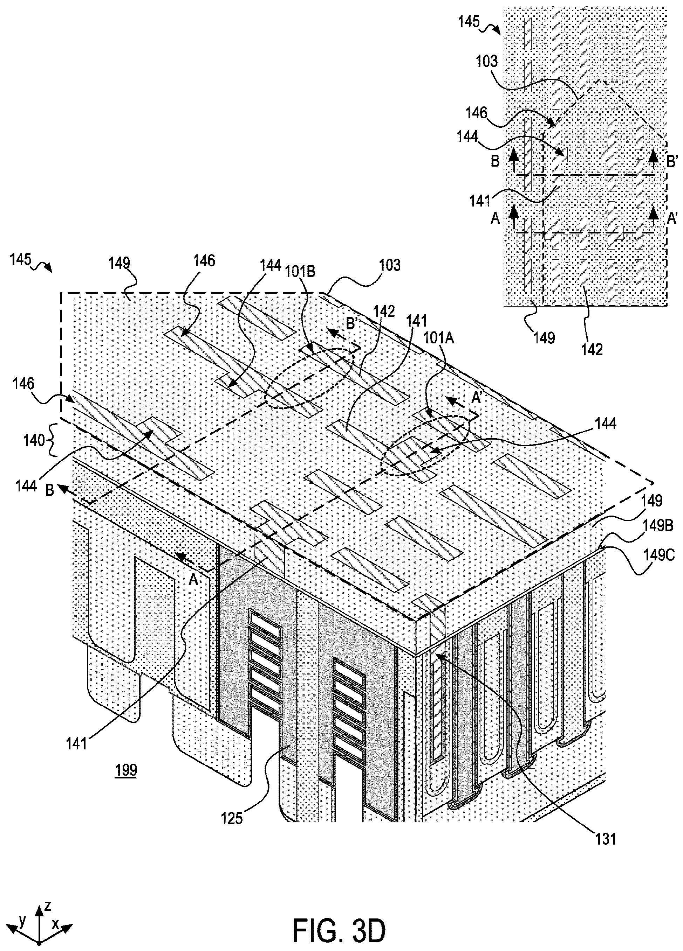

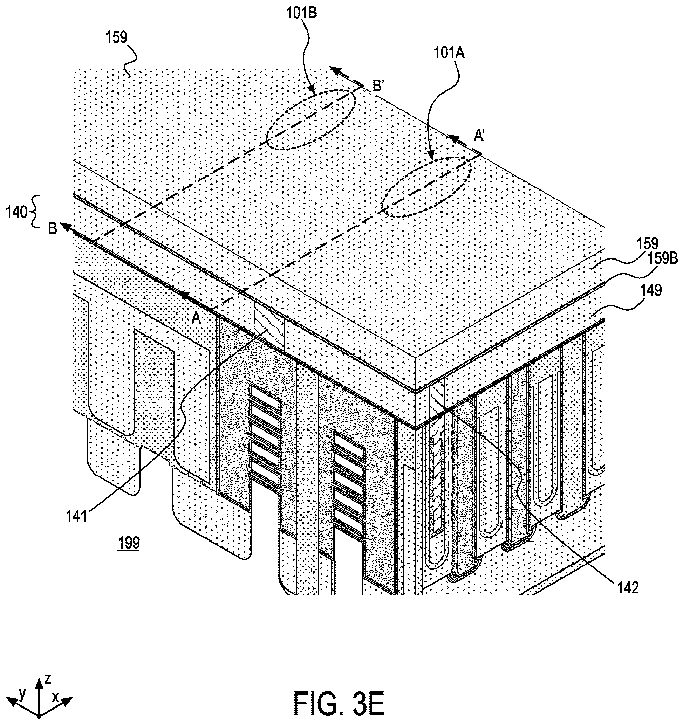

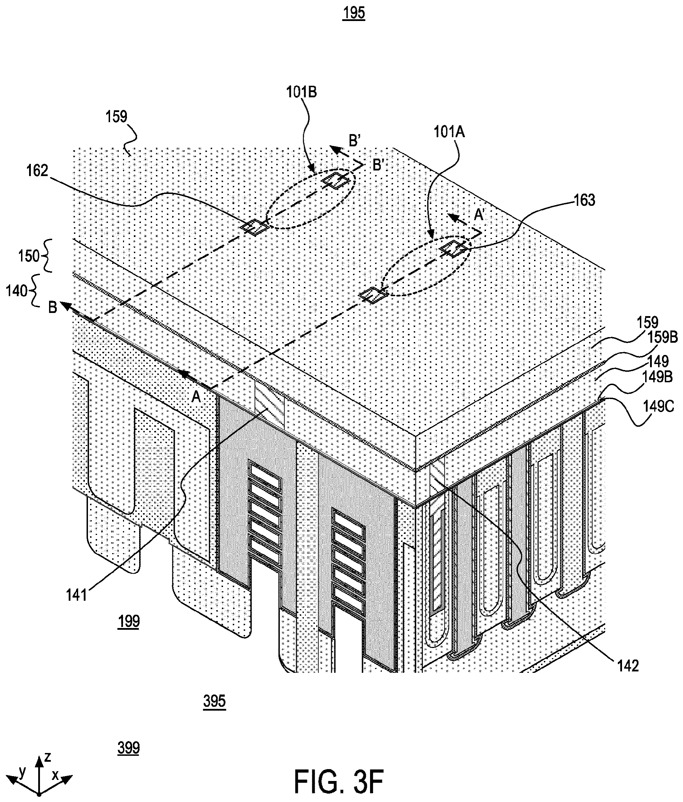

FIGS. 3A, 3B, 3C, 3D, 3E, and 3F illustrate isometric and plan views of IC device 100 having metal bodies 141, 142 in metallization level 140 directly on gate electrodes 125 and contact metals 131, 132 in contact level 130, at various stages of manufacture, in accordance with some embodiments. FIGS. 3A-3F show possible examples of intermediate structures during an embodiment of a practice of methods 200 of FIG. 2.

Returning to FIG. 2, methods 200 begin at operation 210 with planarizing an upper surface of a transistor structure. The transistor structure may be received on or in a substrate, such as an IC die or wafer, e.g., much as described of substrate 199 at FIG. 1A. The transistor structure may be planarized by any suitable means. In many embodiments, the upper surface of the transistor structure is planarized by a CMP (chemical-mechanical planarization or polish) of the substrate. The planarizing (e.g., polishing) may reduce down and smooth out any structures and materials on the upper surface of the substrate and transistor structure. The transistor structure may include a gate electrode (for example, over a channel structure, such as a stack of nanoribbons, nanowires, etc., or a fin), source and drain bodies (e.g., coupled to ends of the channel structure), contacts (e.g., metallization on the source and drain), etc. Planarizing the upper surface of the transistor structure may planarize upper surfaces of source and drain contacts and the gate electrode to approximately level, e.g., a same height, for example, all on a same, planarized upper surface of the transistor structure.

FIG. 3A illustrates coplanar upper surfaces 127, 137 of gate electrodes 125 and drain and source contact metals 131, 132 in transistor structures 101 in a workpiece or IC device 100, in accordance with some embodiments, for example, following a performance of planarizing operation 210. Dashed ovals indicate areas over transistor structures 101A, 101B. Transistor structures 101 may be much as described at FIG. 1C (etc.), with upper surfaces 127 of electrodes 125 and upper surfaces 137 of metals 131, 132 planarized (e.g., polished) to a same level or height at contact plane 134. Dielectric layers 139 provide electrical isolation, for example, between gate electrodes 125 and drain and source contact metals 131, 132. Upper surfaces 127, 137 of electrodes 125 and metals 131, 132 are prepared for operations 220, etc., for example, to link and couple transistor structures 101A, 101B (and other structures 101 on the x-z planes of profile views A-A' and B-B').

Returning to FIG. 2, methods 200 continue at operation 220 with covering a transistor structure with a dielectric layer. A dielectric material may be deposited as a layer over the entire substrate or over selected portions, including on upper surfaces of the gate electrode and of source and drain contacts. The dielectric material may be deposited by any suitable means. In many embodiments, the dielectric material is a low-K dielectric, e.g., to provide good electrical isolation and so to minimize parasitic capacitances between conductive structures. In some embodiments, the dielectric layer is one of multiple dielectric layers deposited over the transistor structure. In some such embodiments, the dielectric layer is a relatively thick, low-K dielectric layer over one or more relatively thin layers that provide etch selectivities (e.g., etch-stop layers that may have somewhat higher permittivities). In some such embodiments, the low-K dielectric layer includes oxygen (e.g., in an oxide, such as an oxide of silicon), and the layer(s) providing etch selectivities include(s) nitrogen (e.g., in a nitride, such as a nitride of silicon).

The dielectric material may be deposited by any suitable means, such as by a chemical vapor deposition (CVD). In some embodiments, multiple dielectric layers are deposited by different means, for example, a thermally grown low-K dielectric layer over an etch-stop layer deposited by an ALD (atomic layer deposition).

FIG. 3B illustrates first dielectric layer 149 (and layers 149B, 149C) over transistor structures 101 in a workpiece or IC device 100, in accordance with some embodiments, for example, following a performance of covering operation 220. Dielectric layers 149B, 149C may be etch-stop layers 149B, 149C, while dielectric layer 149 has a lower dielectric permittivity. Dielectric layers 149 are prepared for operations 230, etc., for example, to link and couple transistor structures 101.

Returning to FIG. 2, methods 200 continue by patterning one or more openings in the dielectric layer at operation 230. The openings may be formed in selected locations, for example, to expose certain structures below the dielectric layer for subsequent coupling with a deposited metal. Holes or gaps may be opened in the dielectric layer over the gate electrode and the source and drain contacts. In many embodiments, gaps are opened in the dielectric layer(s) over gate electrodes and source and drain contacts of multiple transistors. In many embodiments, patterning the one or more openings in the dielectric layer forms an opening with orthogonal portions. For example, a first portion of the opening may extend in a first direction over both the gate electrode and a source or drain contact, and a second portion of the opening may extend in a second, orthogonal direction over a source or drain contact of a second transistor structure. The opening may have multiple perpendicular first and/or second portions. For example, openings may have a single second portion extending over contacts of multiple transistor structures with first portions of the opening branching off orthogonally from over contacts of multiple transistor structures to uncover corresponding gate electrodes.

The openings may be patterned by any suitable means, e.g., photolithographically. For example, a litho mask complex may be deposited, selectively exposed (e.g., in a pattern), and used to remove patterned portions of the dielectric layer, leaving openings exposing structures to be coupled by a metal deposited in the opening(s). In some embodiments (e.g., embodiments with multiple dielectric layers deposited over a planarized upper surface of the transistor structure), multiple etches are employed to expose the underlying structures.

FIG. 3C illustrates openings 341, 342 (including orthogonal portions 344, 346) through dielectric layer 149 over transistor structures 101 in a workpiece or IC device 100, in accordance with some embodiments, for example, following a performance of patterning operation 230. Openings 341, 342 are through dielectric layers 149, 149B, 149C, and gate electrodes 125 and contact metals 131, 132 are exposed in openings 341, 342. Openings 341, 342 may be filled to form corresponding bodies 141, 142. Orthogonal portions 344, 346 of openings 341 may be filled to form corresponding portions 144, 146 of bodies 141. Openings 341, 342 in layers 149 are prepared for operations 240, etc., for example, to link and couple transistor structures 101. For example, openings 341 may be filled with metal(s) to form a linking body 141 (e.g., for linking gate electrodes 125 and contact metals 131, 132 and for contacting by a via 163 for coupling to network 195), and openings 342 may be filled with the same metal(s) to form a body 142 (e.g., for linking contact metals in adjacent transistor structures 101 and for contacting by a via 163 for coupling to network 195).

Returning to FIG. 2, methods 200 continue at operation 240 with depositing a metal in the opening. The deposited metal may be any suitable material and may be deposited by any suitable means. The deposited metal may be deposited on and couple with any gate electrode(s) and source or drain contact(s) exposed by the opening(s). For example, the deposited metal may couple with a gate electrode, couple with a source or drain contact in the same transistor structure and exposed by a same opening in the dielectric layer, and couple the gate electrode and source or drain contact (e.g., to each other by the deposited metal). The metal may be deposited in the opening(s), on an upper (e.g., planarized) surface of the transistor structure, and on the dielectric layer (and/or litho mask(s)) over the transistor structure, for example, with a lower edge or surface of the metal above any gate electrodes, source and drain bodies, and source and drain contacts of the transistor structure.

In embodiments having an opening extending over contacts of multiple transistor structures, depositing the metal in the opening couples the multiple transistor structures. The deposited metal may couple with source or drain contacts exposed by the openings and with any gate electrode(s) exposed by the opening, and the previously exposed contacts and electrode(s) may be covered and coupled by the deposited metal. In many embodiments, the deposited metal is planarized, e.g., down to the dielectric layer, removing any excess metal and leaving a planarized upper surface of the substrate with deposited metal exposed within a layer of dielectric.

The metal may be deposited by any suitable means. In some embodiments, a barrier and/or seed metal is first deposited (e.g., in a thin, conformal layer, for example, by an ALD) on the first dielectric layer and exposed electrode and contact metals (e.g., in a thin, conformal layer, for example, by an ALD). A bulk or fill second metal may then be deposited on (e.g., grown from) the first metal, for example, a different metal deposited by different means. The metal(s) may be as described of bodies 141, 142 (and metals 131, 132, including metal 135 and layer 136) at FIG. 1A.

FIG. 3D illustrates metal bodies 141, 142 linking gate electrodes 125 and contact metals 131, 132 in transistor structures 101 in a workpiece or IC device 100, in accordance with some embodiments, for example, following a performance of depositing operation 240. Metallization level 140 include metal bodies 141, 142 and dielectric layers 149, 149B, 149C. Upper metallization plane 145 is at a top of level 140 and bodies 141, 142 and layer 149. Metal bodies 142 are over and on contact metals 131, 132, and metal bodies 141 are over and on gate electrodes 125 and contact metals 131, 132. Metal bodies 141 include orthogonal portions 144, 146. (Notably, no vias 162 are yet through layer 149.) Metal bodies 141, 142 and dielectric layer 149 are prepared for operations 250, etc., for example, to cover bodies 141, 142 and layer 149 and to couple transistor structures 101.

Returning to FIG. 2, methods 200 continue with covering the dielectric layer and the deposited metal with another dielectric layer at operation 250. This second dielectric may be deposited as a layer of the same or a different dielectric material, over the entire substrate or at least over the first dielectric layer and the deposited metal. The dielectric material may be any suitable material and may be deposited by any suitable means. In many embodiments, the dielectric material is a low-K dielectric material. In some embodiments, multiple dielectric layers are deposited over the first dielectric layer. In some such embodiments, one or more etch-stop layers are first deposited over the metals and first dielectric layer, and a low-K dielectric layer is then deposited over the etch-stop layer(s) to provide electrical isolation.

FIG. 3E illustrates second dielectric layer 159 over metal bodies 141, 142 and first dielectric layer 149 on transistor structures 101 in a workpiece or IC device 100, in accordance with some embodiments, for example, following a performance of covering operation 250. Layer 159C is on metallization level 140 (including bodies 141, 142 and layer 149), and layer 159 is on layer 159C. Dielectric layer 159 and transistor structures 101 are prepared for operations 260, for example, to couple transistor structures 101.

Returning to FIG. 2, methods 200 continue at operation 260 by coupling the transistor structure, for example, to an interconnect network over the transistor structure. In many embodiments, the transistor structure is coupled by forming a via through at least the second dielectric layer. In many embodiments, the transistor structure is coupled by forming a via through the first and second dielectric layers. In many embodiments, the transistor structure is coupled by forming first vias through the second dielectric layer (e.g., down to and contacting a metal deposited at operation 240) and second vias through the first and second dielectric layers (e.g., down to and contacting a gate electrode). In some embodiments, a via is formed through both of the first and second dielectric layers and contacts a source or drain contact.

The via(s) may be of any suitable material(s) and may be formed by any suitable means. For example, a via may be formed of one or more suitable metals, much as described of the metal(s) at operation 240 or of vias 162, 163 described at FIG. 1A (including barrier and/or seed layers 166 and bulk or fill metal 165). The via may be formed by, firstly, opening cavities or holes in and through one or both of the first and second dielectric layers over the transistor structure and, secondly, by depositing one or more metals at least in the openings, much as described by operations 230, 240. Notably, the via openings may extend more deeply and through more dielectric layers, and the vias may contact gate electrodes, source or drain contacts, or tops of the metals deposited at operation 240.

FIG. 3F illustrates vias 162, 163 through interconnect levels 140, 150 to transistor structures 101 in IC device 100, in accordance with some embodiments, for example, following a performance of coupling operation 260. Interconnect level 150 includes dielectric layers 159, 159B. Vias 163 extend through layers 159, 159B and interconnect level 150 and contact bodies 142, and vias 162 extend through layers 149, 149B, 149C, 159, 159B and levels 140, 150 and contact bodies 141. Interconnect network 195 may be formed over metallization level 140 (and may include level 150) and may couple transistor structures 101 by vias 162, 163. Transistor structures 101 may be coupled to a power supply (not shown) by network 195. Transistor structures 101 and network 195 may be coupled to the power supply (not shown) by an optional backside interconnect network 395, opposite network 195.

IC device 100 may include or be coupled to a substrate or other host component 399. Host component 399 may be a package substrate, an interposer, an IC die, etc. For example, substrate 199 may be an IC die that includes transistor structures 101, substrate 199 may be coupled (e.g., soldered or otherwise bonded) to host component 399, and transistor structure 101 may be coupled to a power supply (not shown) through host component 399.

Host component 399 is a planar platform and may include dielectric and metallization structures. Host component 399 mechanically supports and electrically couples one or more IC devices 100. At least one side of host component 399 includes substrate interconnect interfaces for bonding to one or more IC devices 100. IC device 100 may be direct bonded, e.g., hybrid bonded, to host component 399 or otherwise bonded, e.g., by optional solder bumps. The opposite side of host component 399 may include similar interfaces, e.g., copper pads for socketing and/or solder bumps for bonding device 100 to a host component, such as a printed circuit board (PCB). Host component 399 may be any host component with substrate interconnect interfaces, such as a package host component 399 or interposer, etc. Host component 399 may itself be a die. In many embodiments, host component 399 includes organic dielectric(s), such as a resin or other polymer, between metallization layers.

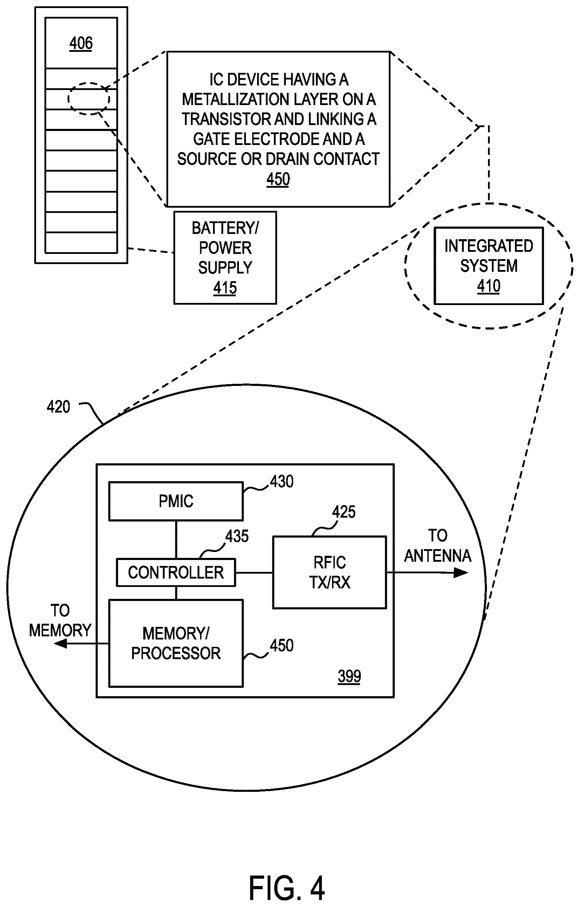

FIG. 4 illustrates a diagram of an example data server machine 406 employing an IC device having a metallization layer on a transistor, linking a gate electrode and a source or drain contact, in accordance with some embodiments. Server machine 406 may be any commercial server, for example, including any number of high-performance computing platforms disposed within a rack and networked together for electronic data processing, which in the exemplary embodiment includes one or more devices 450 having a metallization layer on a transistor, linking a gate electrode and a source or drain contact.

Also as shown, server machine 406 includes a battery and/or power supply 415 to provide power to devices 450, and to provide, in some embodiments, power delivery functions such as power regulation. Devices 450 may be deployed as part of a package-level integrated system 410. Integrated system 410 is further illustrated in the expanded view 420. In the exemplary embodiment, devices 450 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 450 is a microprocessor including a static RAM (SRAM) cache memory. As shown, device 450 may be an IC device having a metallization layer on a transistor, linking a gate electrode and a source or drain contact, as discussed herein. Device 450 may be further coupled to (e.g., communicatively coupled to) a board, an interposer, or other substrate or host component 399 along with, one or more of a power management IC (PMIC) 430, RF (wireless) IC (RFIC) 425 including a wideband RF (wireless) transmitter and/or receiver (TX/RX) (e.g., including a digital baseband and an analog front end module further includes a power amplifier on a transmit path and a low noise amplifier on a receive path), and a controller 435 thereof. In some embodiments, RFIC 425, PMIC 430, controller 435, and device 450 include having a metallization layer on a transistor, linking a gate electrode and a source or drain contact.

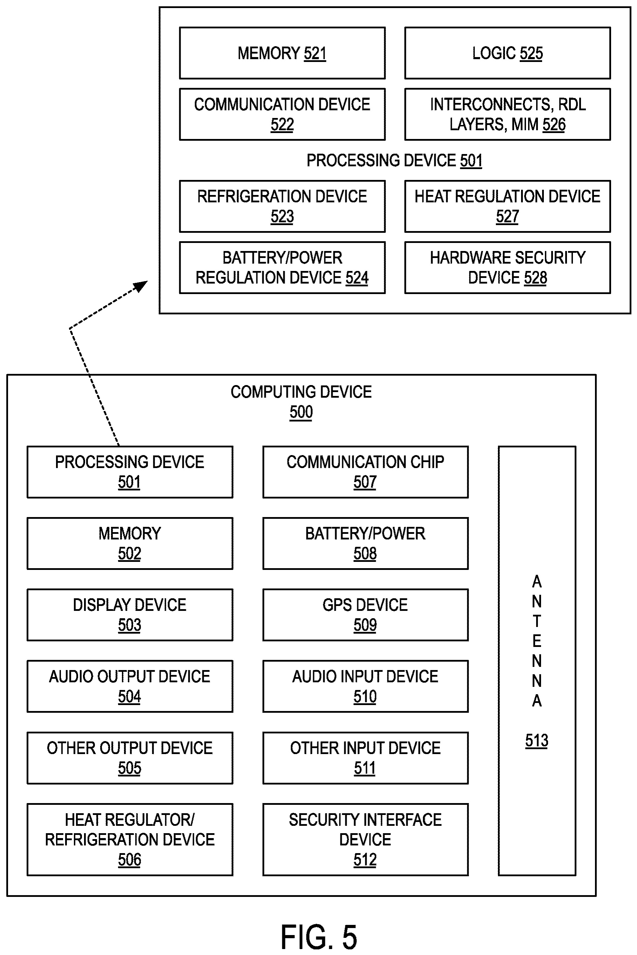

FIG. 5 is a block diagram of an example computing device 500, in accordance with some embodiments. For example, one or more components of computing device 500 may include any of the devices or structures discussed herein. A number of components are illustrated in FIG. 5 as being included in computing device 500, but any one or more of these components may be omitted or duplicated, as suitable for the application. In some embodiments, some or all of the components included in computing device 500 may be attached to one or more printed circuit boards (e.g., a motherboard). In some embodiments, various ones of these components may be fabricated onto a single system-on-a-chip (SoC) die. Additionally, in various embodiments, computing device 500 may not include one or more of the components illustrated in FIG. 5, but computing device 500 may include interface circuitry for coupling to the one or more components. For example, computing device 500 may not include a display device 503, but may include display device interface circuitry (e.g., a connector and driver circuitry) to which display device 503 may be coupled. In another set of examples, computing device 500 may not include an audio output device 504, other output device 505, global positioning system (GPS) device 509, audio input device 510, or other input device 511, but may include audio output device interface circuitry, other output device interface circuitry, GPS device interface circuitry, audio input device interface circuitry, audio input device interface circuitry, to which audio output device 504, other output device 505, GPS device 509, audio input device 510, or other input device 511 may be coupled.

Computing device 500 may include a processing device 501 (e.g., one or more processing devices). As used herein, the term "processing device" or "processor" indicates a device that processes electronic data from registers and/or memory to transform that electronic data into other electronic data that may be stored in registers and/or memory. Processing device 501 may include a memory 521, a communication device 522, a refrigeration device 523, a battery/power regulation device 524, logic 525, interconnects 526 (i.e., optionally including redistribution layers (RDL) or metal-insulator-metal (MIM) devices), a heat regulation device 527, and a hardware security device 528.

Processing device 501 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 500 may include a memory 502, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 502 includes memory that shares a die with processing device 501. This memory may be used as cache memory and may include embedded dynamic random-access memory (eDRAM) or spin transfer torque magnetic random-access memory (STT-MRAM).

Computing device 500 may include a heat regulation/refrigeration device 506. Heat regulation/refrigeration device 506 may maintain processing device 501 (and/or other components of computing device 500) at a predetermined low temperature during operation.

In some embodiments, computing device 500 may include a communication chip 507 (e.g., one or more communication chips). For example, the communication chip 507 may be configured for managing wireless communications for the transfer of data to and from computing device 500. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 507 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 507 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 507 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 507 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 507 may operate in accordance with other wireless protocols in other embodiments. Computing device 500 may include an antenna 513 to facilitate wireless communications and/or to receive other wireless communications (such as AM or FM radio transmissions).

In some embodiments, communication chip 507 may manage wired communications, such as electrical, optical, or any other suitable communication protocols (e.g., the Ethernet). As noted above, communication chip 507 may include multiple communication chips. For instance, a first communication chip 507 may be dedicated to shorter-range wireless communications such as Wi-Fi or Bluetooth, and a second communication chip 507 may be dedicated to longer-range wireless communications such as GPS, EDGE, GPRS, CDMA, WiMAX, LTE, EV-DO, or others. In some embodiments, a first communication chip 507 may be dedicated to wireless communications, and a second communication chip 507 may be dedicated to wired communications.

Computing device 500 may include battery/power circuitry 508. Battery/power circuitry 508 may include one or more energy storage devices (e.g., batteries or capacitors) and/or circuitry for coupling components of computing device 500 to an energy source separate from computing device 500 (e.g., AC line power).

Computing device 500 may include a display device 503 (or corresponding interface circuitry, as discussed above). Display device 503 may include any visual indicators, such as a heads-up display, a computer monitor, a projector, a touchscreen display, a liquid crystal display (LCD), a light-emitting diode display, or a flat panel display, for example.

Computing device 500 may include an audio output device 504 (or corresponding interface circuitry, as discussed above). Audio output device 504 may include any device that generates an audible indicator, such as speakers, headsets, or earbuds, for example.

Computing device 500 may include an audio input device 510 (or corresponding interface circuitry, as discussed above). Audio input device 510 may include any device that generates a signal representative of a sound, such as microphones, microphone arrays, or digital instruments (e.g., instruments having a musical instrument digital interface (MIDI) output).

Computing device 500 may include a GPS device 509 (or corresponding interface circuitry, as discussed above). GPS device 509 may be in communication with a satellite-based system and may receive a location of computing device 500, as known in the art.

Computing device 500 may include other output device 505 (or corresponding interface circuitry, as discussed above). Examples of the other output device 505 may include an audio codec, a video codec, a printer, a wired or wireless transmitter for providing information to other devices, or an additional storage device.

Computing device 500 may include other input device 511 (or corresponding interface circuitry, as discussed above). Examples of the other input device 511 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 500 may include a security interface device 512. Security interface device 512 may include any device that provides security measures for computing device 500 such as intrusion detection, biometric validation, security encode or decode, access list management, malware detection, or spyware detection.

Computing device 500, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1A-5. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes a transistor structure including a source body, a drain body, and a gate electrode over a channel structure, a source contact metal on the source body and a drain contact metal on the drain body, a first metal body in a metallization level, the metallization level interfacing with the source contact metal, the drain contact metal, and the gate electrode, the first metal body on and continuous between the gate electrode and one of the source contact metal or the drain contact metal, and a second metal body in the metallization level, the second metal body on the other of the source contact metal and the drain contact metal.

In one or more second embodiments, further to the first embodiments, the source contact metal, the drain contact metal, and the gate electrode are in a contact level below the metallization level, a lower surface of the first metal body and a lower surface of the second metal body are substantially coplanar in a metallization plane, and an upper surface of the source contact metal, an upper surface of the drain contact metal, and an upper surface of the gate electrode are substantially coplanar in a contact plane above the channel structure, the contact plane interfacing with the metallization plane.

In one or more third embodiments, further to the first or second embodiments, the transistor structure is a first transistor structure, the gate electrode is a first gate electrode, the metallization plane is a first metallization plane, the first and second metal bodies are in a first dielectric layer in the metallization level and over the contact level, a second dielectric layer is over the first dielectric layer and the metallization level, an upper surface of the first metal body and an upper surface of the second metal body are substantially coplanar in a second metallization plane, a first via extends through the second dielectric layer and interfaces with the second metal body at the second metallization plane, and a second via extends through the first and second dielectric layers and interfaces with a second gate electrode of a second transistor structure at the first metallization plane.

In one or more fourth embodiments, further to the first through third embodiments, the first and second metal bodies have a first composition different than a second composition of the first and second vias.

In one or more fifth embodiments, further to the first through fourth embodiments, the first and second metal bodies have a first composition different than a second composition of the source contact metal and the drain contact metal or a third composition of the gate electrode.

In one or more sixth embodiments, further to the first through fifth embodiments, the first composition of the first and second metal bodies is substantially the same as the second composition of the source contact metal and the drain contact metal.

In one or more seventh embodiments, further to the first through sixth embodiments, the first metal body includes first and second portions, the first portion extends in a first direction between the gate electrode and the one of the source contact metal or the drain contact metal, and the second portion of the first metal body extends in a second direction orthogonal to the first direction.

In one or more eighth embodiments, further to the first through seventh embodiments, the transistor structure is a first transistor structure, the source body is a first source body, and the drain body is a first drain body, the source contact metal is a first source contact metal, and the drain contact metal is a first drain contact metal, and the second portion of the first metal body extending in the second direction contacts a second source contact metal or a second drain contact metal on a second source or drain body of a second transistor structure.

In one or more ninth embodiments, further to the first through eighth embodiments, a first distance separating the first and second metal bodies is greater than a second distance separating the gate electrode and the other of the source contact metal and the drain contact metal.

In one or more tenth embodiments, an apparatus includes a transistor structure including a source body, a drain body, and a gate electrode over a channel structure, a source contact metal on the source body and a drain contact metal on the drain body, wherein an upper surface of the source contact metal, an upper surface of the drain contact metal, and an upper surface of the gate electrode are substantially coplanar above the channel structure, and first and second metal bodies in a dielectric layer over the transistor structure, the first metal body in contact with the gate electrode and one of the source contact metal or the drain contact metal, the first metal body continuous between the gate electrode and one of the source contact metal or the drain contact metal, the second metal body in contact with the other of the source contact metal and the drain contact metal.

In one or more eleventh embodiments, further to the tenth embodiments, lower surfaces of the first and second metal bodies are substantially coplanar at a first height above the channel structure, and upper surfaces of the first and second metal bodies are substantially coplanar at a second height above the channel structure.

In one or more twelfth embodiments, further to the tenth or eleventh embodiments, the transistor structure is a first transistor structure, the gate electrode is a first gate electrode, the dielectric layer is a first dielectric layer, a second dielectric layer is over the first dielectric layer, a first via extends through the second dielectric layer to the second height and contacts the second metal body, and a second via extends through the first and second dielectric layers to the first height and contacts a second gate electrode of a second transistor structure.

In one or more thirteenth embodiments, further to the tenth through twelfth embodiments, the first metal body includes first and second portions, the first metal body continuous between the first and second portions, the first portion extends in a first direction between the gate electrode and the one of the source contact metal or the drain contact metal, and the second portion of the first metal body extends in a second direction orthogonal to the first direction.

In one or more fourteenth embodiments, further to the tenth through thirteenth embodiments, the source body is a first source body, the source contact metal is a first source contact metal, the drain body is a first drain body, the drain contact metal is a first drain contact metal, and the second portion contacts a second source contact metal or a second drain contact metal on a second source or drain body of a third transistor structure.

In one or more fifteenth embodiments, further to the tenth through fourteenth embodiments, an integrated circuit (IC) die includes the transistor structure, the IC die is coupled to a substrate, and the transistor structure is coupled to a power supply through the substrate.

In one or more sixteenth embodiments, a method includes covering a transistor structure with a first dielectric layer, the first dielectric layer on a gate electrode and a source or drain contact, the transistor structure including the gate electrode, the source or drain contact, and a source or drain body under the source or drain contact, the source or drain contact on the source or drain body, patterning an opening in the first dielectric layer over the gate electrode and the source or drain contact, depositing a metal in the opening, wherein the metal on the gate electrode and the source or drain contact, and a lower edge of the metal is above the gate electrode and the source or drain contact, and covering the first dielectric layer and the metal with a second dielectric layer.

In one or more seventeenth embodiments, further to the sixteenth embodiments, the method also includes planarizing a first upper surface of the transistor structure, wherein the covering the transistor structure with the first dielectric layer deposits a dielectric material on a second upper surface of the gate electrode and a third upper surface of the source or drain contact, and the second upper surface of the gate electrode and the third upper surface of the source or drain contact are approximately level at a height.

In one or more eighteenth embodiments, further to the sixteenth or seventeenth embodiments, the method also includes coupling the transistor structure by forming a via through at least the second dielectric layer.

In one or more nineteenth embodiments, further to the sixteenth through eighteenth embodiments, the via is a first via, the transistor structure is a first transistor structure, the gate electrode is a first gate electrode, the coupling the transistor structure forms the first via through the second dielectric layer, the first via contacting the source or drain contact, and the method also includes forming a second via through the first and second dielectric layers, the second via contacting a second gate electrode of a second transistor structure.

In one or more twentieth embodiments, further to the sixteenth through nineteenth embodiments, the transistor structure is a first transistor structure, the source or drain contact is a first source or drain contact, the patterning the opening in the first dielectric layer forms orthogonal first and second portions of the opening, the first portion over the gate electrode and the source or drain contact and extending in a first direction, and the second portion extending in a second direction over a second source or drain contact of a second transistor structure, the second direction orthogonal with the first direction, and the depositing the metal in the opening couples the first and second transistor structures.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
a transistor structure comprising a source body, a drain body, and a gate electrode over a channel structure;
a source contact metal on the source body and a drain contact metal on the drain body;
a first metal body in a metallization level, the metallization level interfacing with the source contact metal, the drain contact metal, and the gate electrode, the first metal body on and continuous between the gate electrode and one of the source contact metal or the drain contact metal; and
a second metal body in the metallization level, the second metal body on the other of the source contact metal and the drain contact metal.

2. The apparatus of claim 1, wherein:
the source contact metal, the drain contact metal, and the gate electrode are in a contact level below the metallization level;
a lower surface of the first metal body and a lower surface of the second metal body are substantially coplanar in a metallization plane; and
an upper surface of the source contact metal, an upper surface of the drain contact metal, and an upper surface of the gate electrode are substantially coplanar in a contact plane above the channel structure, the contact plane interfacing with the metallization plane.

3. The apparatus of claim 2, wherein:
the transistor structure is a first transistor structure;
the gate electrode is a first gate electrode;
the metallization plane is a first metallization plane;
the first and second metal bodies are in a first dielectric layer in the metallization level and over the contact level;
a second dielectric layer is over the first dielectric layer and the metallization level; and
an upper surface of the first metal body and an upper surface of the second metal body are substantially coplanar in a second metallization plane;

4. The apparatus of claim 3, wherein
a first via extends through the second dielectric layer and interfaces with the second metal body at the second metallization plane; and
a second via extends through the first and second dielectric layers and interfaces with a second gate electrode of a second transistor structure at the first metallization plane.

5. The apparatus of claim 4, wherein the first and second metal bodies have a first composition different than a second composition of the first and second vias.

6. The apparatus of any one of claims 1-5, wherein the first and second metal bodies have a first composition different than a second composition of the source contact metal and the drain contact metal or a third composition of the gate electrode.

7. The apparatus of claim 6, wherein the first composition of the first and second metal bodies is substantially the same as the second composition of the source contact metal and the drain contact metal.

8. The apparatus of any one of claims 1-7, wherein:
the first metal body comprises first and second portions;
the first portion extends in a first direction between the gate electrode and the one of the source contact metal or the drain contact metal; and
the second portion of the first metal body extends in a second direction orthogonal to the first direction.

9. The apparatus of claim 8, wherein:
the transistor structure is a first transistor structure;
the source body is a first source body, and the drain body is a first drain body;
the source contact metal is a first source contact metal, and the drain contact metal is a first drain contact metal; and
the second portion of the first metal body extending in the second direction contacts a second source contact metal or a second drain contact metal on a second source or drain body of a second transistor structure.

10. The apparatus of any one of claims 1-9, wherein a first distance separating the first and second metal bodies is greater than a second distance separating the gate electrode and the other of the source contact metal and the drain contact metal.

11. A method, comprising:
covering a transistor structure with a first dielectric layer, the first dielectric layer on a gate electrode and a source or drain contact, the transistor structure comprising the gate electrode, the source or drain contact, and a source or drain body under the source or drain contact, the source or drain contact on the source or drain body;
patterning an opening in the first dielectric layer over the gate electrode and the source or drain contact;
depositing a metal in the opening, wherein the metal on the gate electrode and the source or drain contact, and a lower edge of the metal is above the gate electrode and the source or drain contact; and
covering the first dielectric layer and the metal with a second dielectric layer.

12. The method of claim 11, further comprising planarizing a first upper surface of the transistor structure, wherein:
covering the transistor structure with the first dielectric layer comprises depositing a dielectric material on a second upper surface of the gate electrode and a third upper surface of the source or drain contact; and
the second upper surface of the gate electrode and the third upper surface of the source or drain contact are approximately level at a height.

13. The method of claim 11 or 12, further comprising coupling the transistor structure by forming a via through at least the second dielectric layer.

14. The method of claim 13, wherein the via is a first via, the transistor structure is a first transistor structure, the gate electrode is a first gate electrode, the coupling the transistor structure forms the first via through the second dielectric layer, the first via contacting the source or drain contact, and the method further comprises forming a second via through the first and second dielectric layers, the second via contacting a second gate electrode of a second transistor structure.

15. The method of claim 14, wherein:
the transistor structure is a first transistor structure;
the source or drain contact is a first source or drain contact;
patterning the opening in the first dielectric layer forms orthogonal first and second portions of the opening, the first portion over the gate electrode and the source or drain contact and extending in a first direction, and the second portion extending in a second direction over a second source or drain contact of a second transistor structure, the second direction orthogonal with the first direction; and depositing the metal in the opening couples the first and second transistor structures.
